# EUROPEAN PATENT SPECIFICATION

(11) **EP 2 656 356 B1**
(45) Date of publication and mention of the grant of the patent: **09.08.2017**
(21) Application number: 10798104.5
(22) Date of filing: 23.12.2010
(51) Int. Cl.: H01B 3/18, H01B 3/20, H01B 13/14, H01B 3/44

(54) **CONTINUOUS PROCESS FOR MANUFACTURING A HIGH VOLTAGE POWER CABLE**
KONTINUIERLICHES VERFAHREN ZUR HERSTELLUNG EINES HOCHSPANNUNGSKABELS
PROCÉDÉ EN CONTINU POUR LA FABRICATION D'UN CÂBLE DE PUISSANCE HAUTE TENSION

(43) Date of publication of application: 30.10.2013
(73) Proprietor: Prysmian S.p.A., 20126 Milano (IT)
(72) Inventor: POZZATI, Giovanni, I-20126 Milano (IT); BAREGGI, Alberto, I-20126 Milano (IT); CRISCI, Vincenzo, I-20126 Milano (IT)
(74) Representative: Colombo, Stefano Paolo
(86) International application number: PCT/EP2010/070677
(87) International publication number: WO 2012/084055

(56) References cited:
- WO-A1-2004/066317
- GB-A- 1 469 748
- US-A- 5 182 066

## Description

### Technical field

The present invention relates to the field of energy cables. In particular, the present invention relates to a process and apparatus for manufacturing a high voltage power cable comprising a conductor and a polymeric coating layer. The cable may be used for either direct current (DC) or alternating current (AC) transmission or distribution.

### Background art

An energy cable for transporting or distributing electric energy typically comprises at least one cable core. Each cable core is usually formed by at least one conductor, made of a conductive metal, sequentially surrounded by an inner semiconductive layer, an insulating layer and an outer semiconductive layer. If the cable is for high voltage applications, the at least one cable core is typically surrounded by a screen layer, which may be made of metal or metal and polymeric material. The screen layer may be in the form of wires (braids), of tapes helically wound around the at least one cable core or of a metal sheet, optionally coated with a polymer, wrapped around the at least one cable core and having longitudinal rims overlapped one another and welded or glued.

The inner semiconductive layer, the insulating layer and the outer semiconductive layer are typically polymeric layers.

Such polymeric layers are typically made from a polyolefin-based crosslinked polymer, in particular crosslinked polyethylene (XLPE), or elastomeric ethylene/propylene (EPR) or ethylene/propylene/diene (EPDM) crosslinked copolymers, as disclosed e.g. in WO 98/52197. The crosslinking step is carried out after extruding the polymeric material onto the conductor and gives the material satisfactory mechanical and electrical properties even under the very high temperatures (e.g. 90°C-105C°) which are typically reached in high voltage applications. After extrusion and crosslinking, the cable - coiled on a reel or spool - must be subjected to a degassing step, during which the volatile chemicals produced by the crosslinking reaction and entrapped within the cable layers are released. The degassing period is typically quite long (up to 50 days or even more, depending on the number of layers and thickness thereof) and represents a stand-by period in the manufacturing process of the cable that increases the production time and cost. This manufacturing step is particularly critical for DC cables.

As an alternative to crosslinked polymers, the polymeric layers of an energy cable may be made from thermoplastic materials, i.e. materials which are not crosslinked and that accordingly do not require a degassing step during the manufacturing process of the cable. In this respect, electric cables comprising at least one coating layer, for example the insulating layer, based on a polypropylene matrix intimately admixed with a dielectric fluid are known and disclosed in WO 02/03398, WO 02/27731, WO 04/066318, WO 07/048422 and WO 08/058572. The polypropylene matrix useful for this kind of cables comprises polypropylene homopolymer or copolymer or both, characterized by a relative low crystallinity such to provide the cable with the suitable flexibility, but not to impair the mechanical properties and thermopressure resistance at the cable operative and overload temperatures. Performance of the cable coating, especially of the insulating layer, is also affected by the presence of the dielectric fluid intimately admixed with the polypropylene matrix.

These thermoplastic materials are suitable for use in energy cables for high voltage applications, provided that the compounding of the polypropylene matrix and the dielectric fluid is very intimate and very homogeneous.

Further, to obtain a very high dielectric strength, which is essential in high voltage applications, the thermoplastic materials should be substantially free from contaminants.

US 5,182,066 discloses a process and apparatus for applying a layer of insulation around an electrical cable core. The pellets of insulation material are worked under heat and pressure in an extruder, such as a screw extruder. Then, the insulation material is supplied directly through a filter, which removes the particles of contaminants larger than a predetermined size. The filtered insulation material is then received by a pump, such as a gear pump, which supplies the filtered insulation material to a mixer, such as a static mixer, from which the material exits into the cross-head of a conventional extruder which applies the material to the cable core. If a cross-linking agent is used, the cross-linking agent is injected intermediate the pump and the mixer. The pump is necessary to push the filtered insulation material through the mixer and to provide the necessary pressure on the insulation material at the input of the extrusion cross-head.

WO-A-2004/066317 discloses a cable comprising at least one electrical conductor and at least one extruded covering layer based on a thermoplastic polymer material in admixture with a dielectric liquid. GB-A-1 469 748 discloses an apparatus for coating wire including at least one coating composition dispensing means for feeding a plurality of positive displacement delivery units, a wire coating die associated with each positive displacement delivery unit, a haul-off device for coated wires and a cabling device for the coated wires whereby two or more wires may be formed into a cable.

### Summary of the invention

The Applicant observes that the process and apparatus described by US 5,182,066 is not suitable for extruding a coating layer made from the above described polymeric mixture polypropylene matrix/dielectric fluid.

Indeed, as mentioned above, the polypropylene matrix and dielectric fluid should be very intimately and homogeneously admixed, especially for use in energy cables for high voltage applications. However, it has been found that the screw extruder is not capable of admixing the polypropylene matrix and dielectric fluid as intimately and homogeneously as required for high voltage applications.

Moreover an increase of the pressure in the mixture to be extruded can bring the mixture to a temperature that results in an excessive fluidity, possibly causing irregular extrusion and/or complicating the cooling procedure thereafter.

A compounding machine or compounder could be envisaged for preparing the mixture polypropylene matrix/dielectric fluid, typically in form of pellets to be then charged in an extruder, but the possibility of setting up a continuous manufacturing process (from the starting materials to the final product) is appealing from an industrial point of view, because of the shorter production time and of the lessening of risk of contamination of the materials.

However, the possibility of connecting a compounder to an extrusion head is not eligible because the pressure that the compounder can impart to the mixture is too low for an industrially convenient flow rate from the extrusion head. The presence of a filter, necessary for removing possible contaminants harmful for the high voltage current transport, brings to a further reduction of the flow pressure.

In view of the above, the Applicant has tackled the problem of providing a process and apparatus for manufacturing a high voltage power cable comprising a conductor and a polymeric coating layer, which overcomes the aforesaid drawbacks.

In particular, the Applicant has tackled the problem of providing a process and apparatus for manufacturing a high voltage power cable comprising a conductor and a polymeric coating layer, the coating layer being made from a polymeric mixture polypropylene matrix/dielectric fluid, said process and apparatus being apt to allow compounding the polypropylene matrix with the dielectric fluid in a very intimate and homogeneous way, to allow abating the presence of contaminants in the mixture and, at the same time, to allow extruding the mixture on the conductor at an industrially acceptable rate. The process should be continuous at least from the starting material compounding step to the insulated conductor cooling step.

This problem is solved by a process comprising compounding the polypropylene matrix and the dielectric fluid in a compounder, said compounder continuously providing the mixture propylene matrix/dielectric liquid to a volumetric pump that pushes the mixture through a filter removing possible contaminants up to an extrusion head of an extruder, which extrudes the mixture around the conductor as it advances in its longitudinal direction.

The function of compounding the polypropylene matrix/dielectric fluid mixture and the function of providing a pressure suitable for the extrusion of the mixture - including the pressure drop induced by the filter - are performed by two distinct devices, which may be independently chosen so that each of these two functions is separately optimized.

In particular, the function of compounding the mixture polypropylene matrix/dielectric fluid is performed by a compounder which, differently from a screw extruder, is capable of admixing the polypropylene matrix and the dielectric fluid as intimately and homogeneously as required by high voltage applications.

On the other hand, the function of providing the mixture with the suitable pressure is performed by a volumetric pump interposed between the compounder and the filter. The volumetric pump is preferably operated such that it raises the pressure of the mixture flow by an amount ΔP2. The amount ΔP2 depends on the pressure drop caused by the filter and by the extrusion head. Such pressure drop has to be pre-compensated so as to extrude the mixture on the conductor at an industrially acceptable rate, both in terms of amount and constancy. The volumetric pump is capable of exerting a steady pressure on the mixture without substantial temperature increase.

For the purpose of the present description and of the claims, except where otherwise indicated, all numbers expressing amounts, quantities, percentages and so forth are to be understood as being modified in all instances by the term "about". Also, all ranges include any combination of the maximum and minimum points disclosed and include any intermediate range therein, which may or may not be specifically enumerated herein.

In the present description and in the claims, as "conductor" it is meant an electrically conducting element usually made from a metallic material, more preferably aluminium, copper or alloy thereof, either as a rod or as a stranded multi-wire, or a conducting element as above coated with a semiconductive layer.

In the present description and in the claims, as "coating layer" it is meant a layer surrounding the conductor in an energy cable. The coating layer may be in direct contact with the conductor. Alternatively, the coating layer may be external to one or more further layers interposed between the conductor and the coating layer. The coating layer may be either a semiconductive layer or an insulating layer.

For the purpose of the invention, the term "high voltage" means voltages higher than 35 kV.

According to a first aspect, the present invention relates to a process for manufacturing an energy cable comprising at least one conductor and at least one polymeric coating layer, the process comprising:
- compounding a polypropylene matrix and a dielectric fluid to obtain a polymeric mixture;
- raising flow pressure of the polymeric mixture;
- filtering the polymeric mixture;
- causing the polymeric mixture to flow through an extrusion head to produce the coating layer on the conductor; and
- cooling the cable;
such that the raised flow pressure enables extrusion at a flow rate greater than 100 kg/h.

Advantageously, the process of the invention is continuous. As "continuous process" it is intended a process made of steps carried out one after the other without significant stops.

The compounding step is performed by a kneader.

Profitably, the step of raising the flow pressure is performed by a volumetric pump.

Preferably, the filtering step comprises removing particles of contaminants larger than 40 µm, more preferably larger than 10 µm.

Preferably, the step of causing the polymeric mixture to flow through an extrusion head (hereinafter also referred to as "extrusion step") is carried out at a temperature not higher than 240°C.

Preferably, the cooling step is performed in a cooling tube with a catenary profile.

Profitably, the cooling step is performed under pressure.

Advantageously, the raised flow pressure enables extrusion at a flow rate greater than 150 kg/h, more preferably greater than 200 kg/h, even more preferably greater than 400 kg/h. An upper limit cannot be envisaged.

According to a second aspect, the present invention provides an apparatus for manufacturing an energy cable comprising at least one conductor and at least one polymeric coating layer, the apparatus sequentially comprising:
- a compounder configured to compound a polypropylene matrix and a dielectric fluid, thereby providing a polymeric mixture;
- a volumetric pump configured to pump the polymeric mixture;
- a filter configured to remove contaminants from the polymeric mixture;
- an extrusion head configured to extrude the polymeric mixture on the conductor, thereby forming the coating layer; and
- a cooling section.

The compounder is a kneader.

Preferably, the volumetric pump is a gear pump.

Profitably, the compounder, the volumetric pump, the filter and the extrusion head are concatenated each other so as to form a continuous manufacturing line. The cooling section can be concatenated as well or can be provide in line after further devices suitable for providing the cable with additional layers

According to advantageous embodiments, the cooling section comprises a cooling tube connected at an output of the extrusion head.

Preferably, the cooling tube has a catenary profile.

Profitably, the cooling tube is pressurized.

Preferably the process and apparatus of the present invention are intended for extruding a polymeric coating layer with electrically insulating properties, i.e. an insulating layer. As "insulating layer" it is meant a covering layer made of a material having a dielectric rigidity (dielectric breakdown strength) of at least 5 kV/mm, preferably greater than 10 kV/mm.

### Brief description of the drawings

The present invention will become fully clear by reading the following detailed description, to be read by referring to the accompanying drawings, wherein:
- Figure 1 is a schematic view of the apparatus according to a preferred embodiment of the present invention;
- Figure 2 is a graph of the pressure of the mixture within a portion of the apparatus of Figure 1; and
- Figure 3 is a perspective view of an energy cable, particularly suitable for high voltage applications, produced according to the invention.

### Detailed description of preferred embodiments of the invention

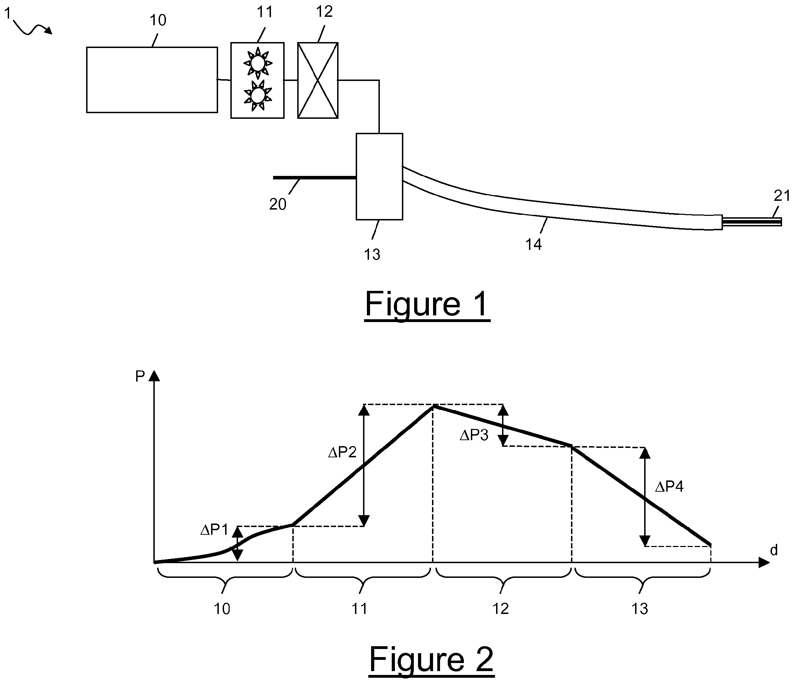

Figure 1 shows an apparatus 1 for extruding a coating layer made from a polymeric mixture on the conductor of an energy cable, the polymeric mixture comprising a polypropylene matrix admixed with a dielectric fluid.

The apparatus 1 comprises a compounder 10, a volumetric pump 11 connected at the output of the compounder 10, a filter 12 connected at the output of the volumetric pump 11, an extrusion head 13 connected at the output of the filter 12 and a cooling tube 14 connected at the output of the extrusion head 13. The compounder 10, the volumetric pump 11, the filter 12, the extrusion head 13 and the cooling tube 14 are concatenated each other so as to form a continuous manufacturing line (or plant). The apparatus 1 may comprise other parts connected upstream the compounder 10 and/or downstream the cooling tube 14, which are not shown in Figure 1 because they are not relevant to the present description.

The compounder 10 is preferably a kneader, for example a ko-kneader or Buss-kneader. This type of compounder is preferred because it has higher mixing capabilities than other types of compounder. Further, the compounding temperature may be readily controlled, the cleaning and maintenance operations are simple and the size is very compact.

For example, the compounder 10 may comprise at least one hopper, preferably two, for supplying at least one polymer, preferably two (e.g. in the form of pellets) at a rate of at least 50 kg/h, up to 1000 kg/h or even more, and at least one dosing unit for supplying at least one fluid (in particular, a dielectric fluid) at a rate of from 2% to 10% the rate of polymer supplying. The compounder may also comprise a degassing system (e.g. comprising a vacuum pump) and a temperature control system.

The volumetric pump 11 is preferably a gear pump. This type of pump is particularly advantageous because of its constant output and of the negligible mixture temperature increase even when high pressure rises are exerted. This is an important requirement, because the temperature of the mixture is a critical parameter during extrusion, as will be better explained in the following. In addition, the flow rate of the mixture at the output of the volumetric pump is almost independent from the pressure and may be adjusted by suitably operating the pump (e.g. by suitably adjusting the number of revolutions per time unit).

The filter 12 can be a sintered filter or, preferably, a mesh filter. A filter system, optionally comprising an automatic filter changing device, can be employed, too. The filter 12 is configured to prevent the passage therethrough of particles larger than 40 µm, more preferably larger than 10 µm. The filter 12 may be provided with a heating system (e.g. comprising electrical resistors) for maintaining the suitable mixture viscosity.

The extrusion head 13 comprises an extrusion dies system (not shown in Figure 1).

The cooling tube 14 preferably has a catenary profile (i.e. a hyperbolic cosine profile) and comprises a cooling fluid, preferably water or nitrogen. Advantageously, the cooling tube 14 is pressurized. Vertical cooling systems, optionally operating with, for example, water or nitrogen, can be envisaged, too.

The apparatus 1 may also comprise a control system (not shown in Figure 1) electrically connected to the compounder 10, to the pump 11, to the filter 12 and to the extrusion head 13, which allows an operator to monitor and control their operation (in particular, dosages, temperatures and flow rates during rump-up, rump-down and steady-state conditions).

The above apparatus is suitable for extruding a coating layer (especially, the insulating layer) on a conductor of a cable. In case more than one coating layer (for example, an inner semiconductive layer, an insulating layer and an outer semiconductive layer) are applied to the conductor with the apparatus of the present invention, the apparatus preferably comprises a compounder, a volumetric pump, a filter and an extrusion head for each coating layer to be applied, though the semiconductive layer(s) can be applied by traditional means.

The operation of the apparatus 1 will be now described in detail, with reference also to the graph of Figure 2.

The components of the polypropylene matrix (e.g. in the form of pellets) and the dielectric fluid are provided to the compounder 10, which kneads them in a highly intimate and homogeneous way, thereby providing at its output a homogeneous thermoplastic mixture.

For instance, the polypropylene matrix may comprise an etherophasic polypropylene (PP) copolymer (e.g. Hifax^{™}) alone, or an etherophasic PP copolymer and a random PP copolymer (e.g. Moplen^{™}). The dielectric fluid may be either an aromatic synthetic liquid (e.g. dibenzyltoluene) or a mineral oil (e.g. Nyflex^{™}). In case a semiconductive layer has to be applied, carbon black is also admixed to the polypropylene matrix.

During the compounding, both the temperature and the flow pressure of the mixture increase, due to the friction forces undergone within the compounder 10. In particular, the flow pressure of the mixture increases by a first amount ΔP1, as shown in Figure 2. This first amount ΔP1 is relatively small, because the compounder 10 is not apt to substantially increase the flow pressure of the mixture.

Then the compounded mixture enters into the volumetric pump 11, which markedly increases its flow pressure by a second amount ΔP2, as shown in Figure 2. In particular, the volumetric pump 11 is operated so that the pressure rise ΔP2 imparted to the mixture pre-compensates the pressure drop that the mixture undergoes as it passes through the filter 12 and allows the mixture reaching the extrusion head 13 with a pressure sufficient to enable the extrusion of a coating layer at an acceptable extrusion rate.

Therefore, advantageously, in the apparatus 1 the function of compounding the polypropylene matrix and the dielectric fluid and the function of raising the mixture flow pressure for compensating the pressure drop induced by the filter are performed by two separate components, which may be independently chosen so that each of these two functions is separately optimized.

In particular, the function of compounding the polypropylene matrix and the dielectric fluid is performed by the compounder 10 which is capable of admixing the polypropylene matrix and the dielectric fluid more intimately and homogeneously than a screw extruder, as required by high voltage applications. Further, the compounder 10 provides a constant dispersion, independently of the flow rate in the working conditions range. Further, the compounder 10 is flexible, i.e. it can be used for compounding thermoplastic materials with different compositions (for example containing an inorganic filler) and it is easy to be cleaned.

The mixture is then passed through the filter 12, which removes the particles of contaminants larger than 40 µm, more preferably larger than 10 µm. As the mixture passes through the filter 12, its pressure decreases by a third amount ΔP3, as shown in Figure 2.

The filtered mixture is then fed to the extrusion head 13, which receives also a conductor 20 advancing at a substantially constant speed along its longitudinal direction. As the conductor 20 advances, the extrusion dies of the extrusion head 13 apply a coating layer 21 of filtered mixture onto the conductor 20. The extrusion operation is preferably carried out at a controlled temperature of from 200 to 240°C. The extrusion temperature is preferably not higher than 240°C because, above such temperature, the mixture becomes so fluid that the extrusion of a layer with homogeneous thickness around the conductor 20 is almost unfeasible. During extrusion, the pressure of the mixture decreases by a fourth amount ΔP4, as shown in Figure 2.

The conductor 20 with the coating layer 21 is then passed through the cooling tube 14, where the coating layer 21 is cooled from the extrusion temperature to a much lower temperature. The cooling fluid within the cooling tube 14 is preferably at a temperature which gradually decreases along the cooling tube 14 and which does not exceed 40°C along the whole tube.

In particular, at the output of the cooling tube 14, the conductor 20 is pulled with a controlled traction force, so that it assumes the same catenary profile as the cooling tube 14. This allows performing the cooling step without leaning the coating layer 21 on any support. Indeed, due to the very low viscosity of the material of the coating layer after extrusion, the contact with a support would deform the coating layer in an undesired way.

It has to be noticed that, after extrusion, the coating layer 21 is very soft due to the high temperature of the extruded material. Hence, especially if the thickness of the coating layer 21 is higher than 10 mm, the extruded material would tend to drop under the effect of its own weight. Such dropping would induce a deformation of the coating layer 21, which becomes eccentric relative to the conductor 20.

Advantageously, this dropping does not take place in the cooling tube 14 of the apparatus 1. Indeed, in the cooling tube 14, the cooling fluid exerts a buoyancy on the coating layer 21, thereby supporting its weight. Hence, advantageously, even if the extruded material is still soft due to the high temperature reached during extrusion, the material does not drop and the concentric shape of the coating layer 21 around the conductor 20 is preserved.

Further, it has to be noticed that, as the extruded mixture (which, immediately after extrusion, has a temperature of about 200°C) enters into contact with the cooling liquid (whose temperature is of about 40°C), voids may be formed within the thickness of the coating layer. This is due to the fact that the outermost portion of the coating layer cools down before the innermost portion and, as it cools down, it solidifies and concentrically tightens around the soft innermost portion. When the innermost part cools down, it also tightens and detachments from the outermost portion can occur. This would causes lack of homogeneity in the coating layer 21 and formation of voids.

Advantageously, such detrimental effects do not take place in the cooling tube 14 of the apparatus 1. Indeed, as mentioned above, the cooling tube 14 is under pressure, and such pressure hinders the formation of the above described mechanical stresses within the thickness of the coating layer. The resulting coating layer is therefore suitably homogeneous and substantially free of voids.

Other layers for completing the cable construction can be provided in a manner known to the skilled in the art. Advantageously, all of the steps for completing the cable manufacturing process are carried out in continuous.

The apparatus above allows extruding a coating layer of mixture polypropylene matrix/dielectric fluid on a conductor in a very efficient way. Indeed, the separation of the compounding function and the pressure raising function allows separately optimizing both such functions. An intimate and homogeneous compounding is indeed provided by the compounder 10, whereas the volumetric pump 11 allows rising in an accurate and efficient way the pressure of the mixture flow.

The Applicant found that the described apparatus allows manufacturing electrical cables in a more efficient way than known apparatuses. In particular, the apparatus 1 allows reaching a speed line two and even three times faster than those of known apparatuses, thanks to the fact that the volumetric pump 11 allows supplying the mixture at the extrusion head 13 at a high pressure and flow rate.

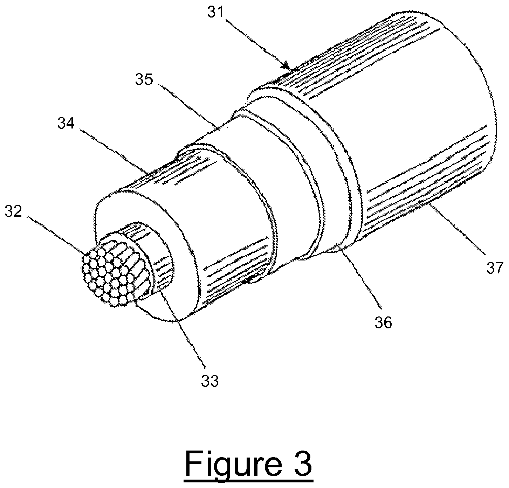

Figure 3 shows a cable 31 produced by the process and apparatus according to the invention.

The cable 31 comprises a conductor 32, an inner semiconductive layer 33, an intermediate insulating layer 34, an outer semiconductive layer 35, a metal screen layer 36 and a sheath 37.

The conductor 32 generally consists of metal wires, preferably of copper or aluminum or alloys thereof, stranded together by conventional methods, or of a solid aluminum or copper rod.

The insulating layer 34 is produced by extrusion, around the conductor 32, of a composition following the teaching of the present invention.

The semiconductive layers 33 and 35 can also made by extruding polymeric mixtures following the teaching of the invention. Preferably, a composition based on a polypropylene matrix and a dielectric fluid is made to be semiconductive by adding at least one conductive filler, usually carbon black.

Around the outer semiconductive layer 35, a metal screen layer 36 is usually positioned, made of electrically conducting wires or strips helically wound around the cable core or of an electrically conducting tape longitudinally wrapped and overlapped (preferably welded or glued) onto the underlying layer. The electrically conducting material of said wires, strips or tape is usually copper or aluminum or alloys thereof.

The screen layer 36 may be covered by a sheath 37, generally made from a polyolefin, usually polyethylene.

The cable can be also provided with a protective structure (not shown in Figure 3), the main purpose of which is to mechanically protect the cable against impacts or compressions.

Energy cables were manufactured using the above described apparatus, in particular a unipolar energy cable for high voltage DC applications (250 kV) and a unipolar energy cable for high voltage AC applications (150 kV). The conductor of each cable was made of copper wires and had a cross-section area of 1000 mm². The apparatus was used for extruding on the conductor an insulating layer. The insulating layer was made of a thermoplastic mixture comprising a polypropylene matrix intimately admixed with a dielectric fluid, as described above. The thickness of the insulating layer was 16 mm.

The manufactured cables were subjected to AC voltage tests, DC voltage tests, lighting pulse tests at 90°C and AC breakdown tests. The results of such tests proved the cables to be in compliance with international and internal standards.

## Claims

1. A process for manufacturing an energy cable comprising at least one conductor (20) and at least one polymeric coating layer (21), said process comprising:
- by a kneader (10), compounding a polypropylene matrix and a dielectric fluid to obtain a polymeric mixture;
- raising flow pressure of said polymeric mixture;
- filtering said polymeric mixture;
- causing said polymeric mixture to flow through an extrusion head (13) to produce said coating layer (21) on said conductor (20); and
- cooling said cable,
such that the raised flow pressure enables extrusion at a flow rate greater than 100 kg/h.

2. The process according to claim 1, which is continuous.

3. The process according to claim 1, wherein said filtering step comprises removing particles of contaminants larger than 40 µm.

4. The process according to claim 3, wherein said filtering step comprises removing particles of contaminants larger than 10 µm.

5. The process according to claim 1, wherein said step of causing the polymeric mixture to flow through an extrusion head (13) is carried out at a temperature not higher than 240°C.

6. The process according to claim 1, wherein said cooling step is performed under pressure.

7. The process according to claim 1, wherein the raised flow pressure enables extrusion at a flow rate greater than 400 kg/h.

8. An apparatus (1) for manufacturing an energy cable comprising at least one conductor (20) and at least one polymeric coating layer (21), the apparatus sequentially comprising:
- a kneader (10) configured to compound a polypropylene matrix and a dielectric fluid, thereby providing a polymeric mixture;
- a volumetric pump (11) configured to pump said polymeric mixture;
- a filter (12) configured to remove contaminants from said polymeric mixture;
- an extrusion head (13) configured to extrude said polymeric mixture on said conductor (20), thereby forming said coating layer (21); and
- a cooling section (14).

9. The apparatus (1) according to claim 8, wherein said volumetric pump (11) is a gear pump.

10. The apparatus (1) according to claim 8, wherein said filter (12) is a mesh filter.

11. The apparatus (1) according to claim 8, wherein said filter (12) is configured to remove contaminants larger than 40 µm.

12. The apparatus according to claim 8, wherein said compounder (10), said volumetric pump (11), said filter (12) and said extrusion head (13) are concatenated each other so as to form a continuous manufacturing line.

## Patentansprüche

1. Verfahren zur Herstellung eines Energiekabels, das mindestens einen Leiter (20) und mindestens eine Polymer-Mantelschicht (21) aufweist, wobei das Verfahren umfasst:
- Mischen einer Polypropylen-Matrix und eines dielektrischen Fluids mittels einer Knetmaschine (10), um eine Polymermischung zu erhalten;
- Erhöhen eines Fließdrucks der Polymermischung;
- Filtern der Polymermischung;
- Bewirken, dass die Polymermischung durch einen Extruderkopf (13) fließt, um die Mantelschicht (21) auf dem Leiter (20) herzustellen; und
- Abkühlen des Kabels,
so dass der erhöhte Fließdruck ein Ziehen bei einer Flussrate ermöglicht, die größer als 100 kg/h ist.

2. Verfahren nach Anspruch 1, das kontinuierlich ist.

3. Verfahren nach Anspruch 1, wobei der Filterschritt Entfernen von Teilchen von Kontaminationsstoffen, die größer als 40 µm sind, umfasst.

4. Verfahren nach Anspruch 3, wobei der Filterschritt Entfernen von Teilchen von Kontaminationsstoffen, die größer als 10 µm sind, umfasst.

5. Verfahren nach Anspruch 1, wobei der Schritt des Bewirkens, dass die Polymermischung durch einen Extruderkopf (13) fließt, bei einer Temperatur ausgeführt wird, die nicht höher als 240 °C ist.

6. Verfahren nach Anspruch 1, wobei der Abkühlschritt unter Druck ausgeführt wird.

7. Verfahren nach Anspruch 1, wobei der erhöhte Fließdruck ein Ziehen bei einer Flussrate ermöglicht, die nicht größer als 400 kg/h ist.

8. Vorrichtung (1) zur Herstellung eines Energiekabels, das mindestens einen Leiter (20) und mindestens eine Polymer-Mantelschicht (21) aufweist, wobei die Vorrichtung der Reihe nach aufweist:
- eine Knetmaschine (10), die ausgebildet ist, eine Polypropylen-Matrix und ein dielektrisches Fluid zu mischen, um damit eine Polymermischung bereitzustellen;
- eine volumetrische Pumpe (11), die ausgebildet ist, die Polymermischung zu pumpen;
- einen Filter (12), der ausgebildet ist, Kontaminationsstoffe aus der Polymermischung zu entfernen;
- einen Extruderkopf (13), der ausgebildet ist, die Polymermischung auf dem Leiter (20) zu ziehen, um dadurch die Mantelschicht (21) zu bilden; und
- einen Kühlabschnitt (14).

9. Vorrichtung (1) nach Anspruch 8, wobei die volumetrische Pumpe (11) eine Zahnradpumpe ist.

10. Vorrichtung (1) nach Anspruch 8, wobei der Filter (12) ein Gewebefilter ist.

11. Vorrichtung (1) nach Anspruch 8, wobei der Filter (12) ausgebildet ist, Kontaminationsstoffe, die größer als 40 µm sind, zu entfernen.

12. Vorrichtung nach Anspruch 8, wobei die Knetmaschine (10), die volumetrische Pumpe (11), der Filter (12) und der Extruderkopf (13) miteinander so der Reihe nach gekoppelt sind, dass sie eine kontinuierliche Fertigungslinie bilden.

## Revendications

1. Procédé de fabrication d'un câble de transport d'énergie comprenant au moins un conducteur (20) et au moins une couche de revêtement polymère (21), ledit procédé comprenant :
- au moyen d'un malaxeur (10), le mélange d'une matrice de polypropylène et d'un fluide diélectrique pour obtenir un mélange polymère ;
- l'augmentation de la pression d'écoulement dudit mélange polymère ;
- la filtration dudit mélange polymère ;
- le fait d'amener ledit mélange polymère à s'écouler à travers une tête d'extrusion (13) pour produire ladite couche de revêtement (21) sur ledit conducteur (20) ; et
- le refroidissement dudit câble,
de telle sorte que la pression d'écoulement augmentée permette une extrusion à un débit supérieur à 100 kg/h.

2. Procédé selon la revendication 1, qui est continu.

3. Procédé selon la revendication 1, dans lequel ladite étape de filtration comprend l'élimination des particules de contaminants supérieures à 40 µm.

4. Procédé selon la revendication 3, dans lequel ladite étape de filtration comprend l'élimination des particules de contaminants supérieures à 10 µm.

5. Procédé selon la revendication 1, dans lequel ladite étape permettant d'amener le mélange polymère à s'écouler à travers une tête d'extrusion (13) est réalisée à une température qui n'est pas supérieure à 240 °C.

6. Procédé selon la revendication 1, dans lequel ladite étape de refroidissement est réalisée sous pression.

7. Procédé selon la revendication 1, dans lequel la pression d'écoulement augmentée permet une extrusion à un débit supérieur à 400 kg/h.

8. Appareil (1) de fabrication d'un câble de transport d'énergie comprenant au moins un conducteur (20) et au moins une couche de revêtement polymère (21), l'appareil comprenant de manière séquentielle :
- un malaxeur (10) conçu pour mélanger une matrice de polypropylène et un fluide diélectrique, pour ainsi obtenir un mélange polymère ;
- une pompe volumétrique (11) conçue pour pomper ledit mélange polymère ;
- un filtre (12) conçu pour éliminer les contaminants à partir dudit mélange polymère ;
- une tête d'extrusion (13) conçue pour extruder ledit mélange polymère sur ledit conducteur (20), pour ainsi former ladite couche de revêtement (21) ; et
- une section de refroidissement (14).

9. Appareil (1) selon la revendication 8, dans lequel ladite pompe volumétrique (11) est une pompe à engrenages.

10. Appareil (1) selon la revendication 8, dans lequel ledit filtre (12) est un filtre à maille.

11. Appareil (1) selon la revendication 8, dans lequel ledit filtre (12) est conçu pour éliminer les contaminants supérieurs à 40 µm.

12. Appareil selon la revendication 8, dans lequel ledit mélangeur (10), ladite pompe volumétrique (11), ledit filtre (12) et ladite tête d'extrusion (13) sont concaténés les uns par rapport aux autres afin de former une ligne de fabrication continue.
